# EUROPÄISCHE PATENTSCHRIFT

(11) **EP 1 113 092 B1**
(45) Veröffentlichungstag und Bekanntmachung des Hinweises auf die Patenterteilung: **17.11.2004**
(21) Anmeldenummer: 00119554.4
(22) Anmeldetag: 07.09.2000
(51) Int. Cl.: C23C 30/00, B23B 27/14, C23C 16/40, C23C 16/30

(54) **Schneidwerkzeug mit mehrlagiger, verschleissfester Beschichtung**
Cutting tool with multilayer, wear resistant coating
Outil de coupe ayant un revêtement multicouche resistant à l'usure

(30) Priorität: 22.12.1999 DE 19962056
(43) Veröffentlichungstag der Anmeldung: 04.07.2001
(73) Patentinhaber: WALTER AG, 72072 Tübingen (DE)
(72) Erfinder: Holzschuh, Helga, Dr., 72537 Mehrstetten (DE)
(74) Vertreter: Rüger, Barthelt & Abel Patentanwälte

(56) Entgegenhaltungen:
- EP-A- 0 980 917
- WO-A-99/23275
- US-A- 4 501 786
- DATABASE WPI Section Ch, Week 197913 Derwent Publications Ltd., London, GB; Class L02, AN 1979-24767B XP002188606 & JP 54 023608 A (SUMITOMO ELECTRIC IND CO), 22. Februar 1979 (1979-02-22)
- PATENT ABSTRACTS OF JAPAN vol. 1996, no. 05, 31. Mai 1996 (1996-05-31) -& JP 08 020871 A (TOSHIBA TUNGALOY CO LTD), 23. Januar 1996 (1996-01-23)
- PATENT ABSTRACTS OF JAPAN vol. 1996, no. 05, 31. Mai 1996 (1996-05-31) -& JP 08 027562 A (TOSHIBA TUNGALOY CO LTD), 30. Januar 1996 (1996-01-30)

## Beschreibung

Die Erfindung betrifft ein Schneidwerkzeug bzw. eine Schneidplatte sowie ein Verfahren zur Herstellung einer Schneidplatte oder eines Schneidwerkzeuges, das eine mehrlagig aufgebaute, verschleißfeste Beschichtung aufweist.

Schneidwerkzeuge unterliegen im Betrieb verschiedenen Belastungen, die mit der Zeit zum Verschleiß führen. Verschleiß beinhaltet die Abnutzung von Span- und Freiflächen sowie Schneidkantenausbruch. Bei hohen Belastungen treten außerdem hohe Temperaturen auf, die Diffusionsverschleiß und Oxidationsverschleiß von Kanten und Flächen des Schneidwerkzeugs bewirken können. Um den Verschleiß auch bei hohen Zerspanungsleistungen zu mindern, sind unterschiedliche Beschichtungen von Schneidwerkzeugen bzw. Schneidplatten entwickelt worden.

Beispielsweise ist aus der EP-0 786 536 A1 eine Schneidplatte aus Hartmetall bekannt, die mit einer mehrlagigen Beschichtung versehen ist. Die Beschichtung weist eine Dicke von 3 bis 20 µm auf, und ist durch chemische oder physikalische Dampfabscheidungsverfahren (CVD oder PVD) auf den Hartmetallkörper ausgebildet wurden. Die Beschichtung enthält eine Aluminiumoxidschicht mit sehr geringem Chloranteil.

Die Aluminiumoxidschicht weist eine relativ große Härte auf. Außerdem wirkt sie als oxidierte Oberflächenschicht, zugleich als Oxidationsschutz für darunter liegende Schichten und ist somit insbesondere für Werkzeuge geeignet, die tribochemischem Angriff unterliegen. Sie wirkt als Schutz vor tribochemischen Verschleißvorgängen wie z.B. Diffusion und Oxidation sowie als Wärmeisolation und somit Schutz vor plastischer Verformung.

Die EP-0 736 615 A2 schlägt ebenfalls eine Aluminiumoxidschicht als außenliegende Schicht einer mehrlagigen Beschichtung eines Schneidwerkzeugs vor. Zwischen der Aluminiumoxidschicht und dem eigentlichen Hartmetallkörper sind mehrere als Unterlage dienende Schichten ausgebildet. Die unmittelbar mit der Aluminiumoxidschicht in Berührung stehende Unterlageschicht ist eine Titancarbonitridoxidschicht mit einer Dicke zwischen 0,1 und 2 µm und nadelförmiger Kristallstruktur. Unter dieser Schicht sind ein oder mehrere aus dem gleichen chemischen Elementen zusammengesetzte Schichten mit columnarer Kristallstruktur ausgebildet.

Wesentlich ist die Haftung der Aluminiumoxidschicht auf der Unterlage. Diese wird insbesondere bei plastischer Verformung und bei unterbrochenem Schnitt (Fräsen, Drehen, Bohren) von Stahl- und Gusswerkstoffen insbesondere bei hochfesten Materialien wie 42CrMo4V und 56NiCrMoV7 beansprucht.

Zur Verbesserung der Haftung einer Aluminiumoxidschicht auf den entsprechenden Unterlagen schlägt die US-PS 59 58 569 eine Titancarbonitrid-Verankerungsschicht zwischen einer außenliegenden Aluminiumoxidschicht und einer darunter liegenden Titannitridschicht vor. Die Verankerungsschicht soll ineinander greifende Finger zwischen der Oxidbeschichtung und der Metallcarbonitridbeschichtung ausbilden.

Aus der JP-A-54 023608 ist es bekannt, zwischen einer Aluminiumoxidschicht und einer Titancarbonitridschicht eine Zwischenschicht aus Aluminiumtitanat anzuordnen. Dies soll die Haftung der Aluminiumoxidschicht verbessern.

Die JP-A-08027562 und die JP-A-08020871 offenbaren darüber hinaus eine TiAlCNO-Schicht als verschleißmindernde Schicht. Diese TiAlCNO-Schicht enthält Titan und Aluminium gleichberechtigt nebeneinander, jeweils in einem at%-Gehalt von 5 % bis 95 %. Die betreffende Schicht ist selbst eine verschleißmindernde Schicht.

Davon ausgehend ist es Aufgabe der Erfindung, die Haftung einer Oxidschicht (vorzugsweise einer Aluminiumoxidschicht) auf darunter liegenden Schichten bei Schneidwerkzeugen, Schneidplatten oder dergleichen zu verbessern.

Diese Aufgabe wird durch das Zerspanungswerkzeug oder eine Schneidplatte nach Anspruch 1 gelöst.

Das erfindungsgemäße Zerspanungswerkzeug bzw. die Schneidplatte weisen eine Aluminiumoxidschicht auf, die mittels einer Verankerungsschicht auf einer Grundschicht gehalten ist. Die Grundschicht ist beispielsweise eine Titannitrid- Titancarbid- oder Titancarbonitridschicht, wobei in der Schicht außer Titan oder anstelle desselben auch andere Metalle der IV., V. oder VI. Nebengruppe des Periodensystems der chemischen Elemente enthalten sein können. Die Verankerungsschicht hält die Aluminiumoxidschicht fest an der Grundschicht und vermeidet so das Abtragen oder Ausbrechen, Abblättern oder Abschälen der Aluminiumoxidschicht wesentlich erschwert ist. Die verbesserte Haftung der Aluminiumoxidschicht auf der Grundschicht ermöglicht eine höhere Belastung des Zerspanungswerkzeugs bzw. der Schneidplatte und/oder eine längere Lebensdauer desselben.

Die Verankerungsschicht enthält ein Metall der IV., V. oder VI. Nebengruppe des Periodensystems der chemischen Elemente sowie ein Element der III. Hauptgruppe des Periodensystems wie beispielsweise Bor oder Aluminium sowie Kohlenstoff und/oder Stickstoff und/oder Sauerstoff. Es hat sich gezeigt, dass das Vorhandensein eines zweiten Elements der III. Hauptgruppe neben dem Metall der IV., V. oder VI. Nebengruppe (beispielsweise Titan) die Haftung der Oxidschicht verbessern kann. Insbesondere hat sich als zweckmäßig herausgestellt, in der Verankerungsschicht Titan und Aluminium vorzusehen. Dabei sollte der Titananteil überwiegen und der Aluminiumanteil eher gering sein. Er wird als Dotierungsmenge begriffen. Die Verankerungsschicht bildet so Kristalle, die fest mit den Kristallen der darüber liegenden Aluminiumoxidschicht verwachsen oder in diese übergehen können. Die Aluminiumoxidschicht ist somit gewissermaßen in der Verankerungsschicht verwurzelt. Dies wird erreicht, indem die Vierankerungsschicht eine TiₓAl_{y}CᵤNᵥO_{w}-Schicht ist, wobei der Aluminiumgehalt höchstens etwa 4at% und der Sauerstoffgehalt höchstens etwa 6at% beträgt. In der Verankerungsschicht kann sich somit Aluminiumtitanat ausbilden, das eine gute Haftung der Aluminiumoxidschicht ermöglich. Zusätzlich kann die Verankerungsschicht zu verhältnismäßig größeren Anteilen Titancarbonitrid enthalten.

Die Verankerungsschicht ist vorzugsweise relativ dünn und zwar deutlich dünner als die Aluminiumoxidschicht und die darunter liegende Grundschicht. Es werden Schichtdicken von 0,1 bis 3 µm als vorteilhaft angesehen. Vorzugsweise beträgt die Schichtdicke 1 µm.

Das Metall der Grundschicht ist vorzugsweise Titan - jedoch kommen auch die anderen genannten Metalle einzeln oder in Mischungen mit Titan oder untereinander in Betracht.

Die Grundschicht kann ihrerseits mehrlagig aufgebaut sein und beispielsweise eine Titannitridschicht von etwa 0,5 µm und/oder eine Titancarbonitridschicht von 1 bis 16 m enthalten. Zusätzlich können als Verunreinigungen z.B. Kohlenstoff und/oder Sauerstoff vorhanden sein, die beispielsweise aus dem Grundmaterial oder sonstigen Quellen herrühren. Die Grundschicht ist vorzugsweise eine im Mitteltemperaturverfahren erzeugte Schicht. Die Verankerungsschicht gestattet die feste Verbindung dieser Mitteltemperaturschicht (Grundschicht) und der Aluminiumoxidschicht. Die Aluminiumoxidschicht kann als α-Aluminiumoxidschicht oder als κ-Aluminiumoxidschicht oder als eine Oxidschicht aufgebaut sein, die mehrere Modifikationen enthält.

Die Verankerungsschicht weist vorzugsweise eine blättchenförmige Kristallstruktur auf. Die blättchenförmigen Kristalle der Verankerungsschicht lassen Zwischenräume frei, in die die Aluminiumoxidschicht hineinwachsen kann, und in denen durch den Aluminiumgehalt der Verankerungsschicht bereits Nukleationskeime für die aufwachsende Aluminiumoxidschicht vorhanden sind. Damit läßt sich eine innige Verbindung zwischen Aluminiumoxidschicht und Verankerungsschicht und somit zwischen der Aluminiumoxidschicht und der Grundschicht erhalten. Es hat sich gezeigt, dass das Oxidationspotential des Reaktionsgasgemischs bei der Abscheidung der Aluminiumoxidschicht vor und während der Keimphase nicht übermäßig niedrig gehalten werden muß. Der Gehalt an Wasser und anderen Oxidantien ist durch die Verankerungsschicht, die schon Nucleationskeime für die Aluminiumoxidschicht enthält, weniger kritisch.

Weitere Einzelheiten vorteilhafter Ausführungsformen der Erfindung sind Gegenstand der Zeichnung, der Beschreibung oder von Unteransprüchen.

In der Zeichnung ist ein Ausführungsbeispiel der Erfindung veranschaulicht. Es zeigen:
Fig. 1 ein Schneidwerkzeug mit einer mehrlagig beschichteten Schneidplatte, in Seitenansicht,
Fig. 2 den Schichtaufbau von Verschleißschutzschichten der Schneidplatte des Schneidwerkzeugs nach Fig. 1, in einer vergrößerten Schnittdarstellung,
Fig. 3 eine transmissionselektronenmikroskopische Aufnahme des Schichtaufbaus nach Fig. 2,
Fig. 3a die Verankerungsschicht nach Fig. 3, schräg angeschliffen als Lichtmikroskopische Aufnahme,
Fig. 4 eine elektronenmikroskopische Aufnahme der Verankerungsschicht in Draufsicht mit fünftausendfacher Vergrößerung,
Fig. 5 die Verankerungsschicht nach Fig. 4, in einer rasterelektronenmikroskopischen Aufnahme mit zehntausendfacher Vergrößerung und
Fig. 6 ein von dem Schichtaufbau nach Fig. 3 hergeleitetes Röntgenspektrogramm.

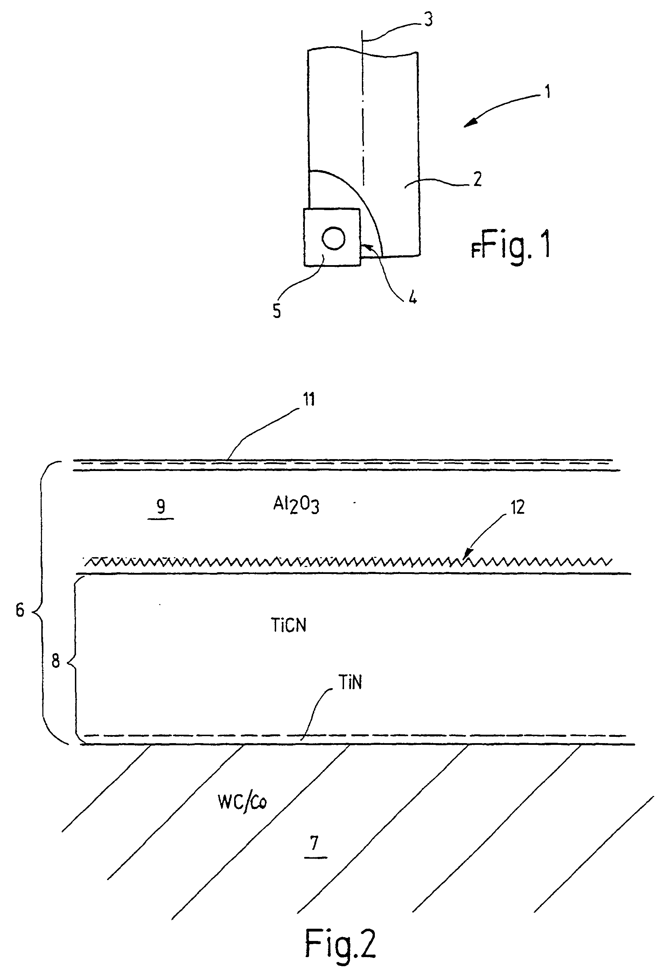

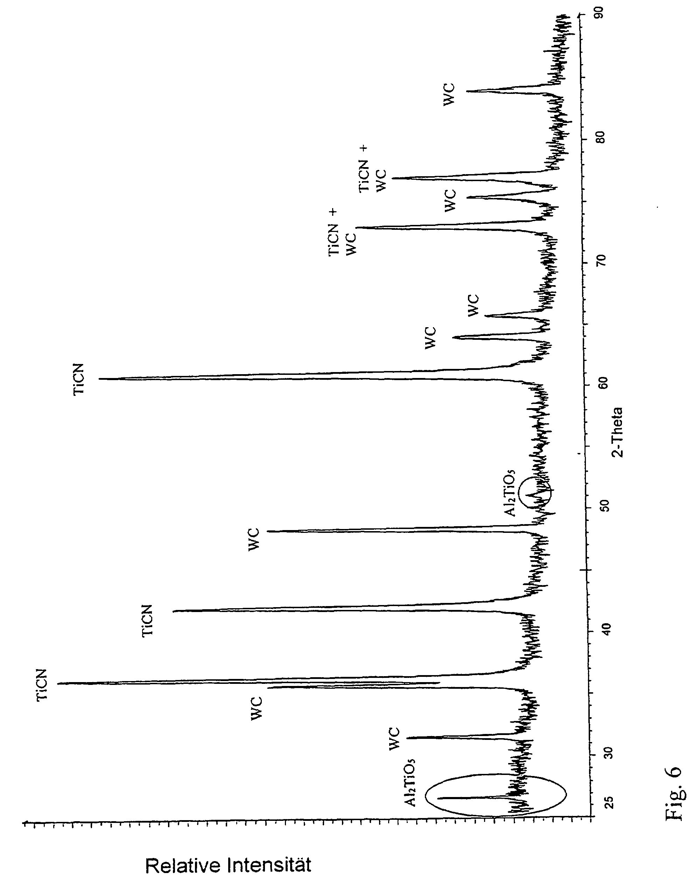

In Fig. 1 ist ein Zerspanungswerkzeug 1 ausschnittsweise und beispielhaft veranschaulicht. Das Zerspanungswerkzeug 1 ist ein Fingerfräser mit einem Werkzeuggrundkörper 2, der in Betrieb um eine Drehachse 3 rotiert. An seinem vorderen Ende weist er einen Plattensitz 4 auf, an dem eine Schneidplatte 5 gehalten ist. Diese Schneidplatte 5 ist beispielsweise eine Hartmetallschneidplatte, z.B. eine Wolframkarbid/Cobalt-Hartmetallschneidplatte. Andere Grundmaterialen, wie z.B. HSS, Sinterkeramiken oder Cermets, Hartmetalle Carbide oder Mischcarbide oder dergl. sind ebenfalls möglich. Die Hartmetallschneidplatte 5 weist eine verschleißmindernde Beschichtung 6 auf, die schematisch in Fig. 6 veranschaulicht ist. Die Beschichtung 6 haftet auf einem Hartmetallgrundkörper 7 und bedeckt diesen sowohl an den Schneidkanten als auch an sonstigen funktionsbestimmenden Flächen beispielsweise der Spanfläche und der Freifläche.

Die verschleißmindernde Beschichtung 6 enthält eine ein- oder mehrlagig aufgebaute Grundschicht 8, die wenigstens zum Großen Teil im Mitteltemperaturverfahren abgeschieden worden ist. Beispielsweise ist die Grundschicht 8 im Wesentlichen eine Titancarbonitridschicht (TiCN) mit columnarer Kristallstruktur und einer Dicke von 1 bis 16 µm. Zwischen der Titancarbonitridschicht und den Grundmaterial Wolframkarbid (WC) kann eine Titannitridschicht (TiN) von etwa 0,1 µm bis 1 µm, vorzugsweise 0,5 µm Dicke angeordnet sein.

Zum Schutz der an sich harten und verschleißfesten Titancarbonitridschicht gegen oxydativen und diffusiven Verschleiß, wie er beispielsweise beim Drehen oder Fräsen auftritt, enthält die verschleißmindernde Beschichtung 6 oberhalb der Grundschicht 8 eine Aluminiumoxidschicht 9. Die Aluminiumoxidschicht 9 kann durch K-Aluminiumoxid, α-Aluminiumoxid oder bereichsweise unterschiedlich ausgebildet sein. Die Aluminiumoxidschicht 9 kann bedarfsweise wiederum eine ein oder mehrlagig aufgebaute Deckschicht 11 tragen, beispielsweise aus einer Verbindung eines Elements der IV., V. od. VI. Nebengruppe (Hf, Zr, Ti) mit Kohlenstoff, Stickstoff und/oder Bor oder ein Zirkondioxid, Aluminiumoxid, Bornitrid, Borcarbid, Titannitrid, Titancarbid oder Titancarbonitrid oder andere Deckschichten.

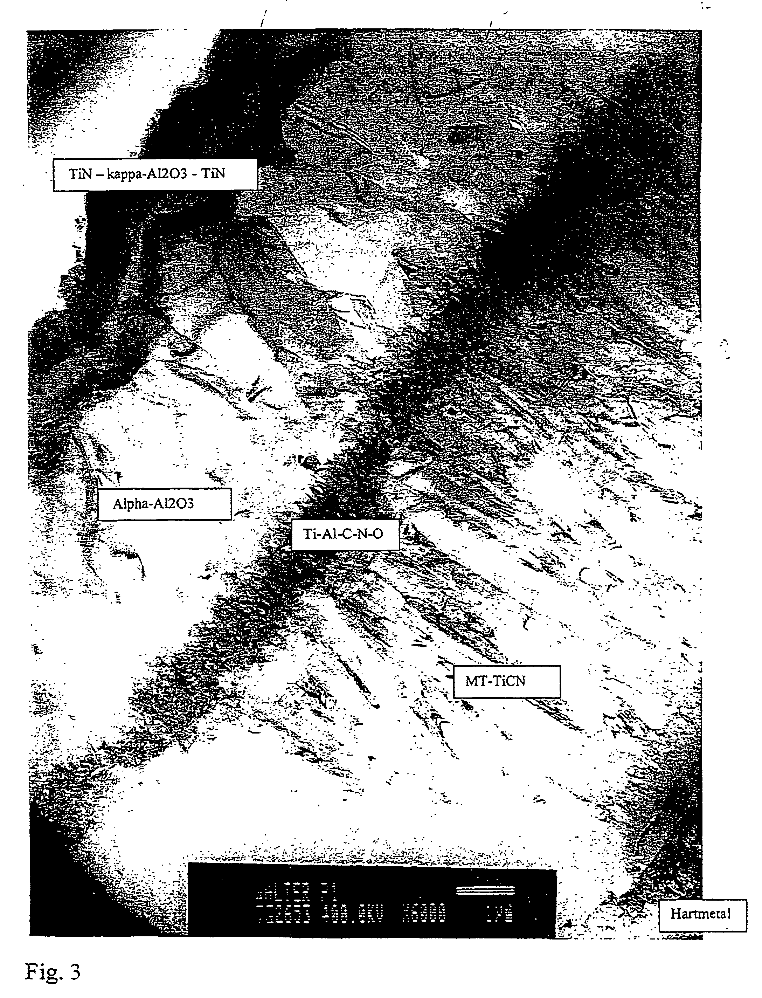

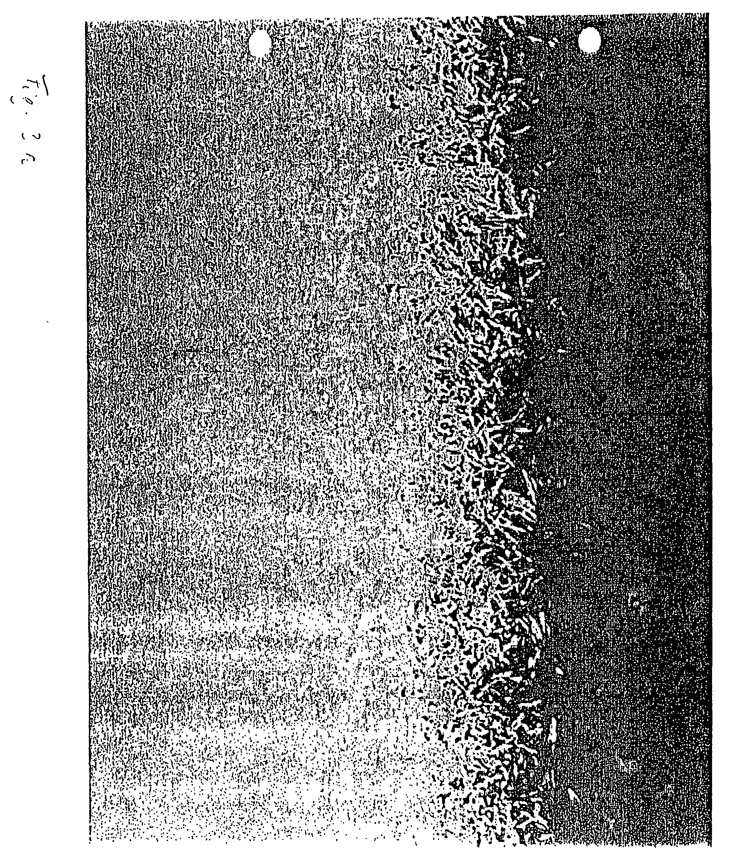

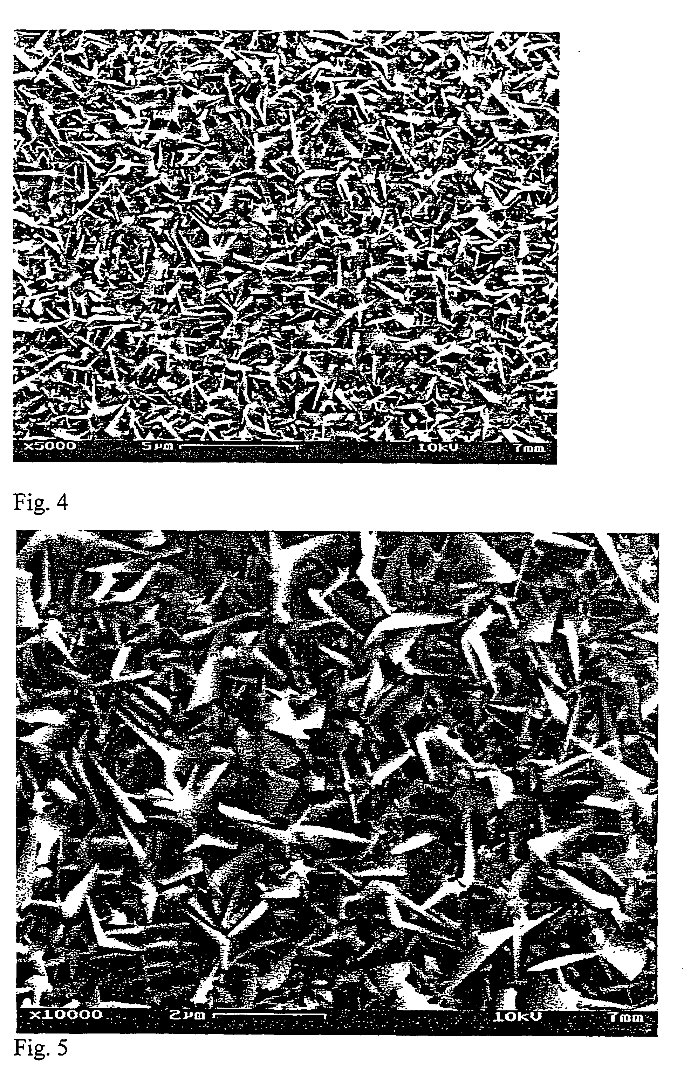

Die Grundschicht 8 enthält außer ihrem Grundbestandteilen Titan, Kohlenstoff und Stickstoff gelegentlich kaum zu vermeidende Verunreinigungen, die aus dem Grundmaterial stammen können oder den Prozessgasen anhaften, wie beispielsweise Sauerstoff. Verunreinigungen durch z.B. Cobalt, das aus dem Grundmaterial stammen kann, diffundieren bevorzugt entlang der Korngrenzen und können somit ausgehend von dem Grundamterial die gesamte Grundschicht 8 durchdringen. Um dennoch unter allem Umständen eine gute Haftung der Aluminiumoxidschicht 9 auf der Grundschicht 8 zu erzielen, ist zwischen beiden eine Verankerungsschicht 12 vorgesehen, deren Dicke im Bereich von 0,1 bis 3 µm bedarfsentsprechend festgelegt werden kann. Die Verankerungsschicht ist hier eine Titanaluminiumcarbonitridoxidschicht Ti-Al-C-N-O, deren Aufbau aus den Fig. 3 bis 5 hervorgeht. Wie Fig 3 zeigt ist die Ti-Al-C-N-O-Schicht 12 auf die Grundschicht 8, die eine kolumnare Struktur aufweist, aufgewachsen und weist an ihrer, der Aluminiumoxidschicht zugewandten Oberseite eine auf äußerste zerklüftete Oberfläche auf. Die Oberflächenstruktur der Ti-Al-C-N-O-Schicht 12 ist in Fig. 4 und 5 veranschaulicht. Sie zeigt eine blättchenförmige Kristallstruktur, wobei zwischen einzelnen Kristalliten Poren und Zwischenräume vorhanden sind. In diesen beginnt beim weiteren Aufbringen der Aluminiumoxidschicht das Kristallwachstum der Aluminiumoxidschicht, die dadurch eine ausgezeichnete Haftung erhält.

Die Deckschicht 11 ist, wie Fig. 3 weiter veranschaulicht, beispielsweise wiederum mehrlagig aufgebaut und enthält eine Ti-N-Schicht, eine κ-Aluminiumoxidschicht und wiederum eine Ti-N-Schicht. Es ergibt sich somit folgender Schichtaufbau:
1. TiN, 0,1 bis 2 µm
2. (MT)-(Ti,C,N)-Grundschicht, 1 bis 16 µm
3. Verankerungsschicht Ti-Al-C-N-O, 0,1 bis 3 µm
4. α- oder κ-Aluminiumoxidschicht Al₂O₃, 0,5 bis 12 µm
5. TiN, 0,1 bis 2 µm
6. eventuell weitere Schichten von insgesamt 0,1 bis 2 µm Dicke, TiN-κ-Al₂O₃-TiN, TiCN/TiN, Ti-B-C-N, HfN, HfCN oder Ähnliches.

Die insoweit beschrieben Beschichtung kann folgendermaßen erzeugt werden:
Zunächst wird bei einer Abscheidetemperatur von 700°C bis 1000 °C auf einem geeignetem Grundmaterial, wie beispielsweise Wolframkarbid oder einem beliebigen anderen Sintermaterial die Grundschicht 8 ausgebildet. Beispielsweise wird als Kohlenstoff und Stickstoffspender Acetonnitril oder eine Mischung aus Stickstoff und Alkanen verwendet. Die Grundschicht wächst meist mit columnarer Kristallstruktur auf.

Im nächsten Verfahrensschritt wird die Verankerungsschicht ausgebildet. Dazu wird das Schneidwerkzeug bzw. die Schneidplatte 5 bei einer zwischen 900°C und 1100°C (vorzugsweise 1000°C) liegenden Temperatur in eine Atomsphäre gebracht, die Precursoren für Aluminium und Titan enthält. Diese Precusoren können Titantetrachlorid und Aluminiumtrichlorid sein. Als Kohlenstoffspender enthält die Atmosphäre Methan oder ein anderes Alkan oder Acetonnitril (CH₃CN) oder andere Nitrile. Weiter ist in der Atmosphäre molekularer Stickstoff sowie ein Sauerstoffspender wie beispielsweise Kohlenmonoxid oder Kohlendioxid vorhanden. Als Trägergas kann Wasserstoff eingesetzt werden.

Aluminiumtrichlorid wird in relativ geringen Mengen beigegeben während Titantetrachlorid in vergleichweise größeren Mengen vorhanden ist. Es wächst dadurch die Verankerungsschicht 12 mit der in den Fig. 4 und 5 veranschaulichten Struktur auf. In Fig. 3a ist ein Schrägschliff einer fertigen Wendeschneidplatte wiedergeben. Er zeigt die schwammartige zur Oberfläche hin immer weiter ausdünnende porige Struktur der Verankerungsschicht. Röntgenspektroskopische Untersuchungen der fertigen Wendeschneidplatte, deren Ergebnisse in Fig. 6 wiedergegeben sind, zeigen das Grundmaterial Wolframkarbid (WC-Co) sowie die vorhandene Titancarbonitridschichten (Ti,C,N) und Aluminiumtitanat (Al₂TiO₅). Dabei liegen Aluminiumtitanat (Al₂TiO₅) und die Titancarbonitrid (TiCₓN_{y}; x+y=1; x=0...1) als makroskopische Kristalle nebeneinander vor. Die Schicht besteht bei einer vorteilhaften Ausführungsform aus Titancarbonitrid mit kubischem Gitter und Stickstoff auf einem Drittel aller Kohlenstoffplätze. Diese Gitter ist sauerstofffrei. Der Sauerstoff ist dann vollständig in den Aluminiumtitanatkristallen gebunden. Diese liegen als Pyseudobrookit vor.

In der Brookit-Struktur, die eine Modifikation von Titanoxid ist (TiO₂) sind einige der Titanatome durch Aluminiumatome ausgetauscht. Beide Metallatomsorten sind verzerrt oktaedrisch von Sauerstoffatomen umgeben, so dass vorzugsweise keine makroskopische Mischung von Titanoxidkristallen und Aluminiumoxidkristallen vorliegt, sondern eine einheitliche Kristallstruktur vorliegt, die vom reinen Brookit (TiO₂) abgeleitet werden kann. Relativ große Bereiche der Zwischenschicht können dabei aus reinem Titancarbonitrid bestehen. Somit ergibt sich eine nahezu optimale Vermittlung zwischen der Aluminiumoxidschicht und der Titancarbonitridschicht. Die Aluminiumtitanatbereiche können relativ klein sein, wobei die gewünschte Wirkung bereits mit Dotierungsmengen Aluminium von weniger 2% erhalten wird. Die Verankerungsschicht ergibt einen epitaktischen Zusammenhang zwischen der Grundschicht und der Al₂O₃-Schicht. Die Verankerungsschicht stört einen sich ergebenden epitaktischen Zusammenhang zwischen Grundschicht und Al₂O₃-Schicht nicht.

Es sind an entsprechend hergestellten Schichten und mit entsprechenden Schneidwerkzeugen Zerspanungstests und Haftungstest durchgeführt worden. Wird die erfindungsgemäße Schicht einem Schichthaftungstest (scratch-test) unterworfen, zeigt sich eine ganz erheblich verbesserte Haftfestigkeit des erfindungsgemäßen Schichtaufbaus, was auch auf eine verbesserte Haftung der Aluminiumoxidschicht schließen läßt. Die Zerspanungstests zeigen ebenfalls eine verbesserte Standfestigkeit der Werkzeuge und eine verbesserte Haftung der Aluminiumoxidschicht sowohl für κ- als auch für α-Aluminiumoxidschichten.

Zur Beschichtung eines Schneidwerkzeugs mit einer Aluminiumoxidschicht ist eine Verankerungsschicht vorgesehen worden, die vorzugsweise durch Aluminiumtitanat gebildet wird und eine blättchenförmige Kristallstruktur aufweist. Diese Verankerungsschicht verbessert die Haftung einer Aluminiumoxidschicht insbesondere auf darunter liegendem Titannitrid, Titancarbid oder Titancarbonitridschichten.

## Patentansprüche

1. Zerspanungswerkzeug (1) oder Schneidplatte (5), insbesondere für unterbrechenen Schnitt und/oder hohe Arbeitstemperaturen,
mit wenigstens einem Schneidkörper (5), der wenigstens bereichsweise mit einer verschleißmindernden mehrlagigen Beschichtung (6) versehen ist, die auf einen Grundwerkstoff (7) aufgebracht ist, wobei die Beschichtung (6) wenigstens folgende ihrerseits ein- oder wiederum mehrlagig aufgebaute Schichten enthält:
eine Grundschicht (8), die eine Nitrid-, Carbidoder Carbonitrid-Schicht eines oder mehrerer Metalle der IV., V. oder VI. Nebengruppe des Periodensystems der chemischen Elemente ist,
eine Titanaluminiumcarbonitridoxid- Verankerungsschicht (12), der Formel TiₓAl_{y}CᵤNᵥO_{w}-Schicht mit x+y =1, und u+v+w=1 ist, wobei y≤0,04 und w≤0,06 und vorzugsweise y≤0,02 und u≤0,03 ist,
eine Oxidschicht (9), die im wesentlichen Aluminiumoxid enthält.

2. Schneidwerkzeug oder Schneidplatte nach Anspruch 1, **dadurch gekennzeichnet, dass** die Verankerungsschicht (12) eine Kristallstruktur mit blättchenförmigen Kristalliten aufweist.

3. Schneidwerkzeug oder Schneidplatte nach Anspruch 1, **dadurch gekennzeichnet, dass** die Verankerungsschicht (12) Aluminumtitanat Al₂TiO₅ enthält.

4. Schneidwerkzeug oder Schneidplatte nach Anspruch 1, **dadurch gekennzeichnet, dass** die Verankerungsschicht (12) Titancarbonitrid TiCN enthält.

5. Schneidwerkzeug oder Schneidplatte nach Anspruch 1, **dadurch gekennzeichnet, dass** die Verankerungsschicht (12) eine Schichtdicke von 0,1 bis 3 µm, vorzugsweise 1 µm aufweist.

6. Schneidwerkzeug oder Schneidplatte nach Anspruch 1, **dadurch gekennzeichnet, dass** das Metall der Grundschicht (8) Titan (Ti) ist.

7. Schneidwerkzeug oder Schneidplatte nach Anspruch 1, **dadurch gekennzeichnet, dass** die Grundschicht (8) mehrlagig aufgebaut ist und eine TiN-Schicht enthält, deren Dicke vorzugsweise nicht größer als 0,5 µm ist, wobei diese Schicht unvermeidbare Spuren bzw. Verunreinigungen von Kohlenstoff (C) und/oder Sauerstoff (O) enthalten kann.

8. Schneidwerkzeug oder Schneidplatte nach Anspruch 1, **dadurch gekennzeichnet, dass** die Grundschicht (8) mehrlagig aufgebaut ist und eine TiCN-Schicht enthält, deren Dicke vorzugsweise im Bereich von 1 bis 16 µm liegt, wobei diese Schicht unvermeidbare Spuren bzw. Verunreinigungen von Sauerstoff (O) enthalten kann.

9. Schneidwerkzeug oder Schneidplatte nach Anspruch 1, **dadurch gekennzeichnet, dass** die Grundschicht (12) eine im Mitteltemperaturverfahren erzeugte Schicht oder Schichtfolge ist.

10. Schneidwerkzeug oder Schneidplatte nach Anspruch 1, **dadurch gekennzeichnet, dass** die Oxidschicht (9) α-Aluminiumoxid enthält.

11. Schneidwerkzeug oder Schneidplatte nach Anspruch 1, **dadurch gekennzeichnet, dass** die Oxidschicht (9) κ-Aluminiumoxid enthält.

12. Schneidwerkzeug oder Schneidplatte nach Anspruch 1, **dadurch gekennzeichnet, dass** auf die Oxidschicht (9) ein oder mehrere weitere Schichten (11) aufgebracht sind.

13. Schneidwerkzeug oder Schneidplatte nach Anspruch 12, **dadurch gekennzeichnet, dass** zu den weiteren Schichten (11) eine TiN-Schicht, eine κ-Aluminiumoxidschicht und eine TiN-Schicht gehören.

## Claims

1. Cutting tool (1) or cutting blade (5), in particular for interrupted cutting and/or high working temperatures,
with at least one cutting body (5), which is provided, at least in regions, with a wear-reducing multilayered coating (6), which is applied to a base material (7), wherein the coating (6) contains at least the following layers, which are themselves of single- or multilayered structure:
a base layer (8), which is a nitride, carbide or carbonitride layer of one or more metals of the IV, V or VI sub-group of the periodic system of chemical elements,
a titanium aluminium carbonitride oxide anchoring layer (12) of the formula TiₓAl_{y}CᵤNᵥO_{w}, where x+y = 1 and u+v+w = 1, wherein y ≤ 0.04 and w ≤ 0.06 and preferably y ≤ 0.02 and u ≤ 0.03,
an oxide layer (9), which essentially contains aluminium oxide.

2. Cutting tool or cutting blade according to Claim 1, **characterised in that** the anchoring layer (12) has a crystal structure with leaf-like crystallites.

3. Cutting tool or cutting blade according to Claim 1, **characterised in that** the anchoring layer (12) contains aluminium titanate Al₂TiO₅.

4. Cutting tool or cutting blade according to Claim 1, **characterised in that** the anchoring layer (12) contains titanium carbonitride TiCN.

5. Cutting tool or cutting blade according to Claim 1, **characterised in that** the anchoring layer (12) has a layer thickness of 0.1 to 3 µm, preferably 1 µm.

6. Cutting tool or cutting blade according to Claim 1, **characterised in that** the metal of the base layer (8) is titanium (Ti).

7. Cutting tool or cutting blade according to Claim 1, **characterised in that** the base layer (8) has a multilayered structure and contains a TiN layer, the thickness of which is preferably not greater than 0.5 µm, wherein this layer can contain unavoidable traces or contaminants of carbon (C) and/or oxygen (O).

8. Cutting tool or cutting blade according to Claim 1, **characterised in that** the base layer (8) has a multilayered structure and contains a TiCN layer, the thickness of which preferably lies in the range of 1 to 16 µm, wherein this layer can contain unavoidable traces or contaminants of oxygen (O).

9. Cutting tool or cutting blade according to Claim 1, **characterised in that** the base layer (8) is a layer or layer sequence generated in the medium temperature process.

10. Cutting tool or cutting blade according to Claim 1, **characterised in that** the oxide layer (9) contains α-aluminium oxide.

11. Cutting tool or cutting blade according to Claim 1, **characterised in that** the oxide layer (9) contains k-aluminium oxide.

12. Cutting tool or cutting blade according to Claim 1, **characterised in that** one or more further layers (11) are applied to the oxide layer (9).

13. Cutting tool or cutting blade according to Claim 12, **characterised in that** the further layers (11) include a TiN layer, a k-aluminium oxide layer and a TiN layer.

## Revendications

1. Outil d'usinage par enlèvement de matière (1) ou plaquette de coupe (5), notamment pour coupe non continue et/ou températures de travail élevées, comportant
au moins un corps de coupe (5) qui, au moins localement, est pourvu d'un revêtement (6) multicouches résistant à l'usure appliqué sur un matériau de base (7), le revêtement (6) présentant au moins les couches suivantes, elles-mêmes formées d'une couche unique ou à nouveau de plusieurs couches:
une couche de base (8) qui est une couche de nitrure, de carbure ou de carbo-nitrure d'un ou de plusieurs métaux appartenant au sous-groupe IV, V ou VI de la classification périodique des éléments chimiques,
une couche d'accrochage (12) d'oxy-carbonitrure de titane-aliminium, de formule TiₓAl_{y}CᵤNᵥO_{w}, avec x+y = 1 et u+v+w = 1, y ≤ 0,04 et w ≤ 0,06 et de préférence y ≤ 0,02 et u ≤ 0,03,
une couche d'oxyde (9) qui contient essentiellement de l'oxyde d'aluminium.

2. Outil d'usinage par enlèvement de matière ou plaquette de coupe selon la revendication 1, **caractérisé par le fait que** la couche d'accrochage (12) présente une structure cristalline à cristallites lamellaires.

3. Outil d'usinage par enlèvement de matière ou plaquette de coupe selon la revendication 1, **caractérisé par le fait que** la couche d'accrochage (12) contient du titanate d'aluminium Al₂TiO₅.

4. Outil d'usinage par enlèvement de matière ou plaquette de coupe selon la revendication 1, **caractérisé par le fait que** la couche d'accrochage (12) contient du carbonitrure de titane TiCN.

5. Outil d'usinage par enlèvement de matière ou plaquette de coupe selon la revendication 1, **caractérisé par le fait que** la couche d'accrochage (12) présente une épaisseur de couche comprise dans une plage allant de 0,1 à 3 µm, de préférence 1 µm.

6. Outil d'usinage par enlèvement de matière ou plaquette de coupe selon la revendication 1, **caractérisé par le fait que** la couche de base (8) est du titane (Ti).

7. Outil d'usinage par enlèvement de matière ou plaquette de coupe selon la revendication 1, **caractérisé par le fait que** la couche de base (8) est formée de plusieurs couches et comprend une couche TiN, dont l'épaisseur, de préférence, n'est pas supérieure à 0,5 µm, cette couche pouvant contenir des traces ou des impuretés inévitables de carbone (C) et/ou d'oxygène (O).

8. Outil d'usinage par enlèvement de matière ou plaquette de coupe selon la revendication 1, **caractérisé par le fait que** la couche de base (8) est formée de plusieurs couches et comprend une couche TiCN, dont l'épaisseur, de préférence, est comprise dans une plage allant de 1 à 16 µm, cette couche pouvant contenir des traces ou des impuretés inévitables d'oxygène (O).

9. Outil d'usinage par enlèvement de matière ou plaquette de coupe selon la revendication 1, **caractérisé par le fait que** la couche de base (8) est une couche ou une suite de couches formée par un procédé moyenne température.

10. Outil d'usinage par enlèvement de matière ou plaquette de coupe selon la revendication 1, **caractérisé par le fait que** la couche d'oxyde (9) contient de l'oxyde d'aluminium alpha.

11. Outil d'usinage par enlèvement de matière ou plaquette de coupe selon la revendication 1, **caractérisé par le fait que** la couche d'oxyde (9) contient de l'oxyde d'aluminium kappa.

12. Outil d'usinage par enlèvement de matière ou plaquette de coupe selon la revendication 1, **caractérisé par le fait que** sur la couche d'oxyde (9) est/sont appliquée(s) une ou plusieurs couches (11) supplémentaires.

13. Outil d'usinage par enlèvement de matière ou plaquette de coupe selon la revendication 12, **caractérisé par le fait que** les couches supplémentaires comprennent une couche TiN, une couche d'oxyde d'aluminium kappa et une couche TiN.
